# FASCICULE DE BREVET EUROPEEN

(11) **EP 4 393 026 B1**
(45) Date de publication et mention de la délivrance du brevet: **07.05.2025**
(21) Numéro de dépôt: 23749131.1
(22) Date de dépôt: 18.07.2023
(51) Int. Cl.: H01M 10/42, G01R 31/385, H01M 10/04, H01M 10/48, G01R 31/3842

(54) **APPAREIL ET PROCÉDÉ D'INSPECTION D'UNE CELLULE SECONDAIRE**
VORRICHTUNG UND VERFAHREN ZUR INSPEKTION EINER SEKUNDÄRZELLE
APPARATUS AND METHOD FOR INSPECTING A SECONDARY CELL

(30) Priorité: 19.07.2022 FR 2207370
(43) Date de publication de la demande: 03.07.2024
(73) Titulaire: Verkor, 38000 Grenoble (FR)
(72) Inventeur: VIDAL, Delphine, 38000 GRENOBLE (FR); HEILMAN, Drew, 38000 GRENOBLE (FR); KIM, Jeong Hyun, 38000 GRENOBLE (FR)
(74) Mandataire: Novagraaf Group
(86) Numéro de dépôt international: PCT/FR2023/051110
(87) Numéro de publication internationale: WO 2024/018151

(56) Documents cités:
- EP-A1- 2 833 434
- EP-A1- 3 428 670
- EP-A1- 3 683 589
- DE-A1- 102020 005 411

## Description

### Domaine technique de l'invention

La présente invention concerne le domaine de la détection des défauts dans une cellule secondaire, en particulier la présente invention concerne un appareil et un procédé d'inspection pour inspecter au moins une cellule secondaire.

### Arrière-plan technique

Lors de la fabrication des cellules secondaires, à savoir des batteries électriques qui peuvent être chargées, déchargées dans une charge électrique, et rechargées de nombreuses fois, et en particulier des sachets souples de cellules secondaires, la contamination de la cellule secondaire est un problème fréquemment rencontré. Cette contamination peut être, par exemple, causée par une particule métallique ou une bavure qui reste à la surface d'une électrode à l'intérieur de la cellule secondaire.

En effet, dans les cellules des batteries lithium-ion, la présence indésirable d'une contamination entre deux électrodes peut provoquer un court-circuit interne à l'intérieur de la batterie lithium-ion, entraînant une défaillance, des dommages et, dans les cas graves, l'inflammation de la batterie.

Cette contamination est particulièrement difficile à détecter dans les cellules secondaires. De nombreuses tentatives ont été faites pour résoudre ce problème. Par exemple, le document EP3415938 A1 décrit une technique pour détecter un défaut de basse tension qui peut se produire dans une cellule secondaire, comprenant une étape d'assemblage d'une batterie secondaire, une étape de vieillissement de la cellule secondaire assemblée, une étape de charge de la cellule secondaire vieillie, et une étape de détection d'un défaut de la cellule secondaire. Si la cellule secondaire présente une chute de tension supérieure à son taux d'autodécharge normal, on considère qu'un défaut de basse tension se produit dans la cellule secondaire.

Cependant, la technique décrite dans le document EP3415938 A1 nécessite un temps considérable du fait des longues étapes de vieillissement impliquées. En outre, la technique décrite ne tient pas compte de l'influence de la variation de température sur les paramètres mesurés.
Un objet de la présente invention est d'inspecter avec précision, facilité et rapidité si un contaminant est présent à l'intérieur d'une cellule secondaire.

### Résumé de l'invention

A cet effet, l'invention a trait à un ppareil d'inspection pour inspecter au moins une cellule secondaire, l'appareil d'inspection comprenant :
- un élément de support fixe ;
- un élément mobile installé pour faire face à l'élément de support et étant mobile par rapport à l'élément de support le long d'un axe principal dans une première direction vers l'élément de support et une seconde direction opposée à la première direction, chaque direction étant le long de l'axe principal ;
- des éléments de pression installés entre l'élément de support et l'élément mobile, lesdits éléments de pression étant librement mobiles le long de l'axe principal, deux éléments de pression adjacents définissant un espace destiné à recevoir une cellule secondaire ;
- une unité d'entraînement configurée pour fonctionner dans un premier état dans lequel l'unité d'entraînement presse l'au moins une cellule secondaire qui se trouve entre les éléments de pression des deux côtés, et un second état dans lequel l'unité d'entraînement libère l'au moins une cellule secondaire ;
- une unité de mesure de pression configurée pour mesurer la pression appliquée par l'unité d'entraînement ;
- une unité de contrôle de courant comprenant une source d'énergie configurée pour appliquer une tension sur l'au moins une cellule secondaire ainsi qu'une unité de mesure de courant pour mesurer un courant correspondant à travers l'au moins une cellule secondaire ;
- chaque élément de pression qui est en contact avec l'au moins une cellule secondaire, comprend un capteur de température, le capteur de température étant destiné à mesurer la température de l'au moins une cellule secondaire qui est soumise à une pression entre les éléments de pression l'appareil d'inspection comprenant une unité de correction de courant pour corriger le courant mesuré par l'unité de mesure de courant afin de prendre en compte une valeur de température de l'au moins une cellule secondaire mesurée par le capteur de température.

Selon un mode de réalisation de l'invention, l'appareil d'inspection comprend en outre un élément de guidage configuré pour guider chaque élément de pression pour qu'il se déplace le long de l'axe principal librement dans la première direction et dans la seconde direction de manière à ajuster l'espace séparant deux éléments de pression adjacents.

Selon un mode de réalisation de l'invention, le capteur de température comprend l'un des éléments suivants : un thermocouple, un détecteur de température à résistance, une thermistance, un capteur de température à circuit intégré.

Selon un mode de réalisation de l'invention, le capteur de température a une résolution comprise entre 0,05°C et 0,5°C.

Selon un mode de réalisation de l'invention, le capteur de température a une plage de température de fonctionnement comprise entre 5°C et 120°C.

Selon un mode de réalisation de l'invention, la source d'énergie est apte à appliquer une tension pour atteindre une valeur de tension par rapport à l'au moins une cellule secondaire mise sous pression par l'élément de pression.

Selon un mode de réalisation, l'appareil d'inspection comprend un module d'électrode connecté à chacune des bornes d'électrode de l'au moins une cellule secondaire pour ainsi appliquer ou recevoir du courant.

Selon un mode de réalisation, l'unité de correction de courant est configurée pour corriger le courant mesuré par l'unité de mesure de courant sur la base d'une courbe d'étalonnage de courant ou de tension.

Selon un mode de réalisation, l'appareil d'inspection comprend un contrôleur qui est connecté à l'unité d'entraînement de pression, au module d'électrode et à l'unité de correction de courant, respectivement, pour commander l'opération de mise sous pression et de relâchement de l'unité d'entraînement de pression, et pour déterminer s'il y a ou non un défaut dans l'au moins une cellule secondaire en comparant la valeur de courant corrigée donnée par l'unité de correction de courant et une valeur de courant de référence.

Selon un mode de réalisation, l'appareil d'inspection comprend un cadre destiné à être installé sur un support, l'élément de support étant installé de manière à être perpendiculaire au cadre,
le cadre comprenant un châssis reposant sur le support et une paire de cadres de support prévus de part et d'autre du châssis pour se faire face l'un l'autre,
et dans lequel :
   l'unité de mesure de pression comprend un capteur de pression interposé entre un élément fixe fixé pour faire face à l'élément de support et le cadre de support prévu sur un côté du châssis,
   le capteur de pression étant configuré pour mesurer une pression lorsque les éléments de pression mettent sous pression l'au moins une cellule secondaire lorsque l'unité d'entraînement est dans son premier état de fonctionnement.

Selon un mode de réalisation, l'unité de mesure de pression comprend un capteur de pression compris entre deux éléments de pression adjacents parmi les éléments de pression.

Selon un mode de réalisation, l'espace est destiné à recevoir une seule cellule secondaire.

Selon un mode de réalisation, l'élément mobile est mobile en translation selon la première direction et la deuxième direction, entre une première position correspondant au premier état et une deuxième position correspondant au deuxième état.

L'invention a aussi trait à un procédé d'inspection pour inspecter au moins une cellule secondaire, le procédé d'inspection comprenant les étapes suivantes :
- fournir un appareil d'inspection tel que précédemment décrit ;
- fournir l'au moins une cellule secondaire à inspecter ;
- introduire l'au moins une cellule secondaire dans l'appareil d'inspection de sorte que l'au moins une cellule secondaire soit introduite entre deux éléments de pression adjacents ;
- appliquer une pression sur et libérer l'au moins une cellule secondaire entre les éléments de pression des deux côtés en déplaçant l'élément mobile par rapport à l'élément de support le long d'un axe principal dans une première direction et une seconde direction opposées l'une à l'autre le long de l'axe principal ;
- mesurer la pression appliquée sur l'au moins une cellule secondaire en utilisant l'unité de mesure de pression afin de déterminer si la pression appliquée est dans une plage de pression prédéfinie ;
- appliquer une tension sur l'au moins une cellule secondaire et mesurer un courant correspondant à travers l'au moins une cellule secondaire ;
- mesurer la température de l'au moins une cellule secondaire avec un capteur de température compris dans chaque élément de pression qui est en contact avec l'au moins une cellule secondaire qui est mise sous pression par les éléments de pression ;
- corriger une valeur du courant mesuré en tenant compte de la valeur de température mesurée de l'au moins une cellule secondaire par le capteur de température ;
- comparer la valeur de courant corrigée à une valeur de courant de référence ;
- trier l'au moins une cellule secondaire comme étant fonctionnelle ou défectueuse sur la base de la comparaison entre la valeur de courant corrigée et la valeur de courant de référence de telle sorte que :
   si la valeur de courant corrigée dépasse la valeur de courant de référence, l'au moins une cellule secondaire est considérée comme défectueuse,
   si la valeur de courant corrigée est inférieure à la valeur de courant de référence, l'au moins une cellule secondaire est considérée comme fonctionnelle.

Selon un mode de réalisation, l'étape consistant à fournir l'au moins une cellule secondaire comprend les sous-étapes suivantes :
- assembler une première électrode et une seconde électrode et un séparateur interposé entre la première électrode et la seconde électrode afin de créer un bobinot ou un empilement ;
- placer le bobinot ou l'empilement dans un boîtier ou un sachet ;
- remplir le boîtier ou le sachet d'un électrolyte ;
- fermer hermétiquement le boîtier ou le sachet afin d'obtenir l'au moins une cellule secondaire ;
- charger l'au moins une cellule secondaire à un état de charge prédéterminé afin de former une interphase d'électrolyte solide sur la surface de la première électrode avant de placer l'au moins une cellule secondaire dans l'appareil d'inspection.

### Brève description des figures

L'invention va maintenant être décrite, à titre d'exemple seulement, en référence aux figures ci-jointes, dans lesquelles :
[Fig.1] la figure 1 une vue en perspective, une vue de dessus et une vue de côté d'un appareil d'inspection selon l'invention.
[Fig.2] la figure 2 est une vue en coupe de l'appareil d'inspection selon la Figure 1.
[Fig.3] la figure 3 est une vue éclatée montrant l'intérieur d'un élément de pression compris dans l'appareil d'inspection et configuré pour mettre sous pression au moins une cellule secondaire.
[Fig.4] la figure 4 est une vue de dessus en coupe d'une autre forme de réalisation de l'élément de pression de la Figure 3 comprenant du conduit de câble incorporé dans l'élément de pression.
[Fig.5] la figure 5 est une vue schématique de l'intérieur d'au moins une cellule secondaire qui est mise sous pression à l'intérieur de l'appareil d'inspection.

Dans ces figures, les mêmes chiffres de référence sont utilisés pour désigner les mêmes éléments. Pour des raisons de clarté, les figures ne sont pas nécessairement reproduites à l'échelle. Des caractéristiques supplémentaires peuvent ressortir de la description suivante.

### Description détaillée

L'invention concerne un appareil d'inspection 1 pour l'inspection d'au moins une cellule secondaire 110 qui peut être un sachet de cellules par exemple.

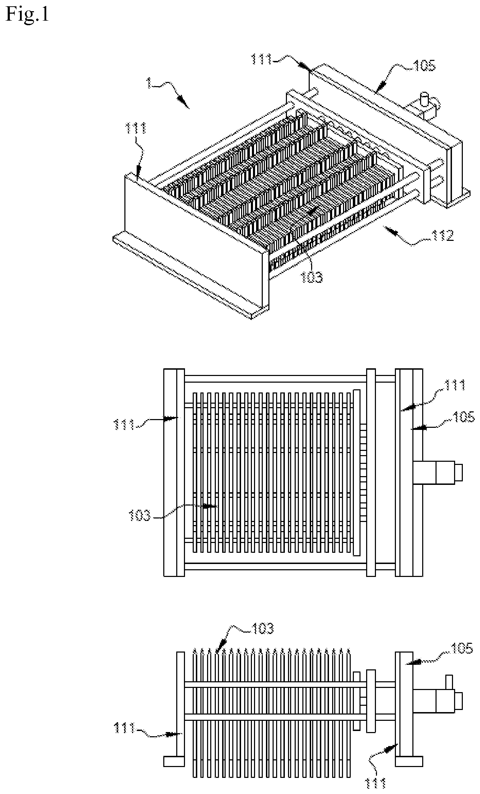

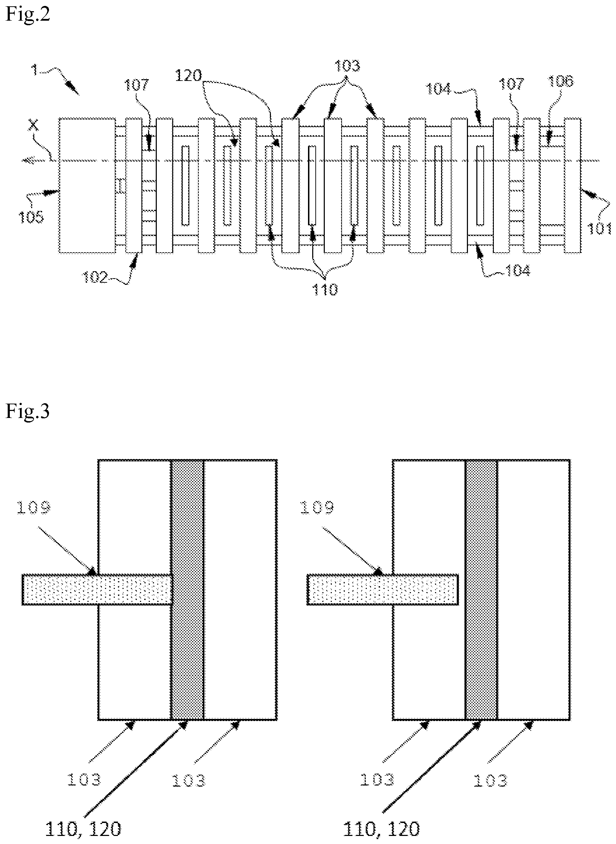

L'appareil d'inspection 1 est présenté sur la Figure 1 et la Figure 2 et comprend un élément de support 101 fixe.

L'élément de support 101 peut être installé de manière à être perpendiculaire à un cadre destiné à être installé sur un support, et le cadre peut comprendre un châssis 112 reposant sur le support et une paire de cadres de support 111 prévus de part et d'autre du châssis 112 pour se faire face l'un l'autre.

L'appareil d'inspection 1 comprend également un élément mobile 102 installé pour faire face à l'élément de support 101 et qui est mobile par rapport à l'élément de support 101 le long d'un axe principal X dans une première direction vers l'élément de support 101 et une seconde direction opposée à la première direction, chaque direction étant le long de l'axe principal X.

La première direction est définie comme la direction selon laquelle l'élément mobile 102 se rapproche de l'élément de support 101 et la seconde direction est définie comme la direction selon laquelle l'élément mobile 102 s'éloigne de l'élément de support 101.

L'appareil d'inspection comprend également des éléments de pression 103 installés entre l'élément de support 101 et l'élément mobile 102 et mobiles librement le long de l'axe principal X. Deux éléments de pression adjacents 103 définissent un espace 120 destiné à recevoir une cellule secondaire 110.

L'espace 120 est destiné à recevoir une seule cellule secondaire 110. En ne recevant qu'une seule cellule secondaire, il est possible d'effectuer des mesures précises sur la cellule 110.

Les éléments de pression 103 peuvent notamment être des panneaux de pression qui peuvent être installés en parallèle entre l'élément de support 101 et l'élément mobile 102.

L'appareil d'inspection 1 comprend également :
- un élément de guidage 104 configuré pour guider chaque élément de pression 103 pour qu'il se déplace le long de l'axe principal X librement dans la première direction et dans la seconde direction de manière à ajuster l'espace 120 séparant deux éléments de pression 103 adjacents ; et
- une unité d'entraînement 105 configurée pour fonctionner dans un premier état dans lequel l'unité d'entraînement 105 presse la au moins une cellule secondaire 110 qui se trouve entre les éléments de pression 103 des deux côtés, et dans un second état dans lequel l'unité d'entraînement 105 libère l'au moins une cellule secondaire 110,
   un changement de fonctionnement entre le premier état et le second état étant obtenu en déplaçant l'élément mobile 102 dans la première direction et dans la seconde direction ;
- une unité de mesure de pression configurée pour mesurer la pression appliquée par l'unité d'entraînement 105.

Avantageusement, l'élément de guidage 104 permet d'obtenir des plaques sensiblement parallèles, permettant d'obtenir des mesures de pression exploitables.

Selon un mode de réalisation, l'unité de mesure de pression comprend un capteur de pression 106 interposé entre un élément fixe fixé pour faire face à l'élément de support 101 et le cadre de support prévu sur un côté du châssis 112, et le capteur de pression 106 peut être configuré pour mesurer une pression lorsque les éléments de pression 103 mettent sous pression l'u moins une cellule secondaire 110 lorsque l'unité d'entraînement 105 est dans son premier état de fonctionnement.

Selon un mode de réalisation, l'unité de mesure de pression comprend un capteur de pression compris entre deux éléments de pression adjacents parmi les éléments de pression 103, et le capteur de pression 106 peut être une cellule de charge, une jauge de contrainte, une résistance sensible à la force ou une combinaison de tous les capteurs de pression cités.

L'appareil d'inspection 1 peut en outre comprendre une unité de support élastique configurée pour supporter de manière élastique l'élément de support 101 pour être ramené du côté de l'élément de pression, dans lequel l'unité de support élastique peut comprendre un élément fixe fixé pour faire face à l'élément de support 101 et un ressort de compression 107 introduit dans l'élément de guidage 104 de manière à être positionné entre l'élément fixe et l'élément de support 101.

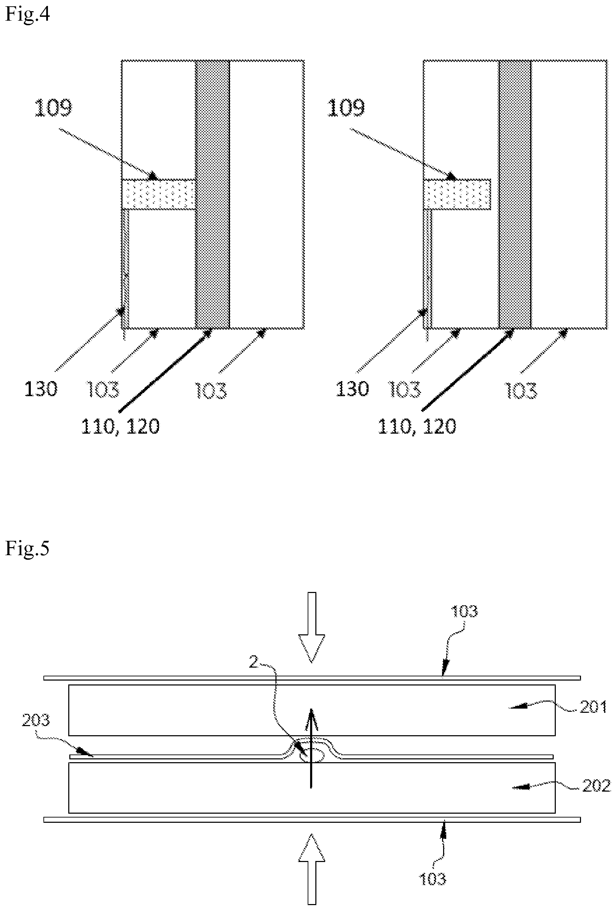

L'appareil d'inspection est remarquable en ce que chaque élément de pression 103 qui est en contact avec l'au moins une cellule secondaire 110, comprend un capteur de température 109 comme on peut le voir sur la figure 3 et la figure 4. Le capteur de température 109 est destiné à mesurer la température de l'au moins une cellule secondaire 110 qui est mise sous pression entre les éléments de pression 103.

Selon un mode de réalisation, le capteur de température 109 comprend l'un des éléments suivants : un thermocouple, un détecteur de température à résistance, une thermistance, un capteur de température à circuit intégré, et le capteur de température 109 présente une résolution comprise entre 0,05°C et 0,5°C.

Selon un mode de réalisation illustré à la figure 4, un conduit de câble 130 est relié au capteur de température 109 et le conduit de câble 130 et le capteur de température 109 sont tous deux encastrés dans l'élément de pression 103. Ceci permet avantageusement de mesurer la valeur de température tout en évitant les surépaisseurs.

Cette plage de résolution permet de détecter de manière précise la température d'au moins une cellule secondaire 110.

Le capteur de température 109 peut avoir une plage de température de fonctionnement comprise entre 5°C et 120°C.

Avantageusement, cette plage de température de fonctionnement est adaptée aux conditions de fonctionnement de l'appareil d'inspection 1.

L'appareil d'inspection 1 comprend en outre une unité de contrôle de courant configurée pour appliquer une tension sur l'au moins une cellule secondaire 110 et pour mesurer un courant correspondant à travers l'au moins une cellule secondaire 110.

L'unité de contrôle de courant peut comprendre :
- une source d'énergie pour appliquer une tension pour atteindre une valeur de tension prédéterminée par rapport à l'au moins une cellule secondaire 110 mise sous pression par les éléments de pression 103 ; et
- une unité de mesure de courant pour mesurer une valeur de courant circulant à travers l'au moins une cellule secondaire 110.

Avantageusement, l'unité de contrôle de courant effectue un contrôle du courant de l'au moins une cellule secondaire 110 mise sous pression, ce qui permet de mesurer le courant circulant à travers l'au moins une cellule secondaire 110.

L'unité de contrôle de courant applique une tension prédéterminée à l'au moins une cellule secondaire 110, et mesure le courant de l'au moins une cellule secondaire 110.

L'appareil d'inspection 1 peut en outre comprendre un module d'électrode connecté à chacune des bornes d'électrode de l'au moins une cellule secondaire 110 pour ainsi appliquer ou recevoir du courant.

L'appareil d'inspection 1 peut en outre comprendre une unité de correction de courant pour corriger le courant mesuré par l'unité de mesure de courant afin de prendre en compte une valeur de température de l'au moins une cellule secondaire 110 mesurée par le capteur de température 109.

L'unité de correction de courant est configurée pour corriger le courant mesuré par l'unité de mesure de courant sur la base d'une courbe d'étalonnage de courant ou de tension.

La courbe d'étalonnage peut être un abaque qui donne des valeurs de courant ou de tension prédéfinies pour l'au moins une cellule secondaire 110 en fonction de la température de l'au moins une cellule secondaire 110. Ces valeurs prédéfinies de courant et de tension peuvent être déterminées expérimentalement.

Ces valeurs pourront varier en fonction d'un retour d'expérience et de la collecte de données, après production et inspection d'un certain nombre de cellules secondaires.

Par « correction du courant mesuré », on entend que la valeur du courant mesuré par l'unité de contrôle de courant est erronée du fait de la dépendance du courant mesuré à la température, et que cette valeur est analysée par l'unité de correction de courant en tenant compte de la dépendance du courant mesuré à la température, afin de donner une valeur de courant corrigée qui tient compte de la dépendance du courant à la température. Cette valeur de courant corrigée est comparée à la valeur de courant de référence.

Selon une autre mode de réalisation, la valeur de courant mesurée est comparée à une valeur de courant de référence corrigée, ce qui signifie que, pour chaque valeur de température, la valeur de courant de référence serait différente.

L'appareil d'inspection 1 comprend en outre un contrôleur qui est connecté à l'unité d'entraînement de pression, au module d'électrode et à l'unité de correction de courant, respectivement, pour commander l'opération de mise sous pression et de relâchement de l'unité d'entraînement de pression, et pour déterminer s'il y a ou non un défaut dans l'au moins une cellule secondaire 110 en comparant la valeur de courant corrigée donnée par l'unité de correction de courant et une valeur de courant de référence.

Le contrôleur peut déterminer s'il y a un défaut en comparant une valeur moyenne des valeurs de courant mesurées par l'unité de contrôle de courant avec la valeur de référence pendant une période de temps prédéterminée qui peut dépendre des paramètres contrôlés par l'utilisateur de l'appareil d'inspection.

La période de temps prédéterminée peut être de 1 à 30 secondes.

La valeur de courant de référence peut être déterminée à partir d'une expérience, par exemple en se référant à une courbe d'étalonnage ou à un abaque qui montre si l'au moins une cellule secondaire 110 est défectueuse ou non en fonction de la valeur de courant mesurée.

L'appareil d'inspection 1 peut permettre l'inspection de nombreuses cellules secondaires 110 simultanément.

L'appareil d'inspection 1 est destiné à mettre sous pression l'au moins une cellule secondaire 110 pour permettre ou améliorer un contact physique entre la première électrode 201 et la seconde électrode 202 à travers le contaminant 2 afin d'induire un courant électrique qui circule à travers le contaminant 2 entre la première électrode 201 et la seconde électrode 202. Comme on peut le voir sur la figure 5, la pression appliquée sur l'au moins une cellule secondaire 110 améliore la détection d'un contaminant potentiel 2 à l'intérieur de l'au moins une cellule secondaire 110 ; le courant circulant à travers le contaminant 2 est donc plus facile à détecter.

La première électrode 201 peut être une cathode et la seconde électrode 202 peut être une anode ou vice versa.

Le fonctionnement de l'appareil d'inspection 1 va maintenant être décrit.

Lorsque l'au moins une cellule secondaire 110 est introduite dans l'appareil d'inspection 1, l'élément mobile 102, installé pour faire face à l'élément de support 101, se déplace dans la première direction et dans la seconde direction le long de l'axe principal X par l'unité d'entraînement 105 pour mettre sous pression et dépressuriser les éléments de pression 103.

L'élément mobile 102 se déplace dans la première direction le long de l'axe principal X afin de mettre sous pression l'au moins une cellule secondaire 110. Un potentiel prédéterminé est appliqué à la cellule et le courant dans l'au moins une cellule secondaire 110 est alors mesuré puis l'élément mobile 102 se déplace dans la deuxième direction le long de l'axe principal X après la mesure du courant afin de libérer l'au moins une cellule secondaire 110.

L'élément mobile 102 est mobile en translation selon la première direction et la deuxième direction, entre une première position et une deuxième position. La première position correspond au premier état dans lequel les cellules sont pressées par l'unité d'entraînement 105, et la deuxième position correspond au deuxième état dans lequel les cellules sont libérées par l'unité d'entraînement 105.

Les éléments de pression 103 mettent sous pression la partie de corps de l'au moins une cellule secondaire 110. Ici, la partie de corps fait référence à la partie de corps de l'au moins une cellule secondaire 110, à l'exception de la borne d'électrode faisant saillie de l'au moins une cellule secondaire 110.

Lorsque les éléments de pression 103 mettent sous pression l'au moins une cellule secondaire 110, l'unité de mesure de pression peut être interposée entre l'élément fixe et le cadre de support pour mesurer la pression.

Si la pression appliquée sur l'au moins une cellule secondaire 110 est trop élevée, l'électrode peut être détachée ou l'apparence de l'au moins une cellule secondaire 110 peut être endommagée. Au contraire, si la pression est trop faible, la première électrode 201 et la seconde électrode 202 peuvent ne pas être physiquement en contact l'une avec l'autre à travers le contaminant 2, de sorte qu'un court-circuit interne peut ne pas être déclenché, ce qui diminue la fiabilité de la détection des défauts. Ainsi, en détectant la pression appliquée sur l'au moins une cellule secondaire 110 par l'intermédiaire du capteur de pression 106, il est possible de vérifier si un niveau approprié de pression est appliqué.

Une tension est ensuite appliquée par l'unité de contrôle de courant afin d'effectuer un contrôle du courant de l'au moins une cellule secondaire 110 sous pression. À cette fin, la source d'énergie comprise dans l'unité de contrôle de courant applique une tension à travers le module d'électrode afin d'atteindre une valeur de tension prédéterminée, et l'unité de mesure de courant mesure la valeur du courant circulant à travers l'au moins une cellule secondaire 110.

L'unité de contrôle de courant et le module d'électrode peuvent être reliés électriquement par un câble, ou tout autre moyen de connexion électrique.

Le module d'électrode relie électriquement l'unité de contrôle de courant à l'au moins une cellule secondaire 110. Le module d'électrode peut être fixé à l'appareil d'inspection 1. Le module d'électrode est connecté à chacune des bornes d'électrode de l'au moins une cellule secondaire 110 et applique le courant appliqué par l'unité de contrôle de courant à l'au moins une cellule secondaire 110, ou transfère le courant de l'au moins une cellule secondaire 110 à l'unité de contrôle de courant.

Le courant mesuré étant sensible aux variations de température, la température de l'au moins une cellule secondaire 110 est mesurée à l'aide du capteur de température 109 compris dans chaque élément de pression 103 qui est en contact avec l'au moins une cellule secondaire 110. Grâce à l'unité de correction de courant, il est possible d'obtenir une valeur de courant mesurée corrigée tenant compte de la dépendance du courant vis-à-vis de la température. Cela permet de comparer la valeur de courant corrigée à la valeur de courant de référence tout en tenant compte de la température de la cellule, et aide à éviter les erreurs de tri.

Ensuite, le contrôleur qui est connecté à l'unité d'entraînement 105, au module d'électrode et à l'unité de correction de courant, compare la valeur de courant corrigée obtenue par l'unité de correction de courant et la valeur de courant de référence afin de déterminer s'il y a ou non un défaut. En outre, le contrôleur peut comparer la valeur de courant corrigée de l'au moins une cellule secondaire 110 mesurée par l'unité de contrôle de courant avec une valeur de référence prédéterminée d'un bon produit et détermine si la valeur est acceptable selon les critères prédéterminés. Le résultat de la détermination peut être affiché par une unité d'affichage non représentée.

Le contrôleur détermine donc si l'au moins une cellule secondaire 110 est bonne ou non selon que la valeur mesurée en fonction de la quantité d'électricité mesurée ou du degré d'isolation correspond à une norme prédéterminée et peut permettre à l'unité d'affichage ou à un dispositif de sortie de données d'afficher le résultat de la détermination pour au moins une cellule secondaire 110.

L'invention concerne également un procédé d'inspection pour inspecter au moins une cellule secondaire 110.

Le procédé d'inspection comprend une étape consistant à fournir un appareil d'inspection 1 tel que décrit précédemment et une étape consistant à fournir l'au moins une cellule secondaire 110 à inspecter.

Afin de fournir l'au moins une cellule secondaire 110 à inspecter, les sous-étapes suivantes peuvent être exécutées :
- assembler au moins la première électrode 201 et la seconde électrode 202 et un séparateur 203 interposé entre la première électrode 201 et la seconde électrode 202 afin de créer un bobinot ou un empilement ;
- placer le bobinot ou l'empilement dans un boîtier ou un sachet ;
- remplir le boîtier ou le sachet d'un électrolyte ;
- fermer hermétiquement le boîtier ou le sachet afin d'obtenir l'au moins une cellule secondaire 110 ;
- charger l'au moins une cellule secondaire 110 à un état de charge prédéterminé afin de former une interphase d'électrolyte solide sur la surface de la première électrode 201 avant de placer l'au moins une cellule secondaire 110 dans l'appareil d'inspection.

Selon une possibilité, un bobinot ou un empilement peut être créé en assemblant de nombreuses premières électrodes, de nombreuses secondes électrodes, de nombreux séparateurs et d'autres couches supplémentaires.

Ensuite, une fois que l'appareil d'inspection 1 et l'au moins une cellule secondaire 110 à inspecter sont fournis, les étapes suivantes sont exécutées :
- introduire l'au moins une cellule secondaire 110 dans l'appareil d'inspection 1 de telle sorte que l'au moins une cellule secondaire 110 soit introduite entre deux éléments de pression adjacents 103 ;
- appliquer une pression sur et libérer l'au moins une cellule secondaire 110 entre les éléments de pression 103 des deux côtés en déplaçant l'élément mobile 102 par rapport à l'élément de support 101 le long d'un axe principal X dans la première direction et la seconde direction opposées l'une à l'autre le long de l'axe principal X ;
- mesurer la pression appliquée sur l'au moins une cellule secondaire 110 en utilisant l'unité de mesure de pression afin de déterminer si la pression appliquée se trouve dans une plage de pression prédéfinie qui peut être comprise entre 200 et 5 000 kgf/cm2 ;
- appliquer une tension sur l'au moins une cellule secondaire 110 et mesurer un courant correspondant à travers l'au moins une cellule secondaire 110 ;
- mesurer la température de l'au moins une cellule secondaire 110 avec un capteur de température 109 compris dans chaque élément de pression 103 qui est en contact avec l'au moins une cellule secondaire 110 qui est soumise à une pression par les éléments de pression 103 ;
- corriger une valeur du courant mesuré en tenant compte de la valeur de température mesurée de l'au moins une cellule secondaire 110 par le capteur de température 109.

Ensuite, afin de trier l'au moins une cellule secondaire 110 comme étant fonctionnelle ou défectueuse, les étapes suivantes peuvent être exécutées :
- comparer la valeur de courant corrigée à une valeur de courant de référence ;
- trier l'au moins une cellule secondaire 110 comme étant fonctionnelle ou défectueuse sur la base de la comparaison entre la valeur de courant corrigée et la valeur de courant de référence de telle sorte que :
   - si la valeur de courant corrigée dépasse la valeur de courant de référence, l'au moins une cellule secondaire 110 est considérée comme défectueuse,
   - si la valeur de courant corrigée est inférieure à la valeur de courant de référence, l'au moins une cellule secondaire 110 est considérée comme fonctionnelle.

Le capteur de pression 106 permet de vérifier si la valeur de la pression appliquée est appropriée ou non.

Avantageusement, le procédé d'inspection décrit permet de prendre en compte la dépendance à la température du courant mesuré à travers l'au moins une cellule secondaire 110, et de corriger le courant mesuré avant de le comparer à une valeur de référence.

Le courant mesuré circulant à travers la cellule secondaire dépend de la température et sera donc mesuré de manière plus précise en utilisant le procédé d'inspection décrit.

Le procédé d'inspection décrit permet un tri plus précis de l'au moins une cellule secondaire 110 inspectée.

Avantageusement, le procédé d'inspection peut être appliqué pendant un processus de fabrication de l'au moins une cellule secondaire 110 après une phase d'impregnation de l'électrolyte, et avant une première charge de l'au moins une cellule secondaire 110.

Avantageusement, le procédé d'inspection peut être appliqué après la formation de la cellule.

Le procédé et l'appareil d'inspection décrits précédemment ont une application industrielle dans le domaine de la fabrication de cellules secondaires.

Ce qui s'applique dans cette description détaillée au procédé d'inspection s'applique également à l'appareil d'inspection, et vice versa.

## Revendications

1. Appareil d'inspection (1) pour inspecter au moins une cellule secondaire (110), l'appareil d'inspection comprenant :
- un élément de support (101) fixe ;
- un élément mobile (102) installé pour faire face à l'élément de support (101) et étant mobile par rapport à l'élément de support (101) le long d'un axe principal (X) dans une première direction vers l'élément de support (101) et une seconde direction opposée à la première direction, chaque direction étant le long de l'axe principal (X) ;
- des éléments de pression (103) installés entre l'élément de support (101) et l'élément mobile (102), lesdits éléments de pression (103) étant librement mobiles le long de l'axe principal (X), deux éléments de pression adjacents (103) définissant un espace (120) destiné à recevoir une cellule secondaire (110) ;
- une unité d'entraînement (105) configurée pour fonctionner dans un premier état dans lequel l'unité d'entraînement (105) presse l'au moins une cellule secondaire (110) qui se trouve entre les éléments de pression (103) des deux côtés, et un second état dans lequel l'unité d'entraînement (105) libère l'au moins une cellule secondaire (110) ;
- une unité de mesure de pression configurée pour mesurer la pression appliquée par l'unité d'entraînement (105) ;
- une unité de contrôle de courant comprenant une source d'énergie configurée pour appliquer une tension sur l'au moins une cellule secondaire (110) ainsi qu'une unité de mesure de courant pour mesurer un courant correspondant à travers l'au moins une cellule secondaire (110)
- chaque élément de pression (103) qui est en contact avec l'au moins une cellule secondaire (110), comprend un capteur de température (109), le capteur de température (109) étant destiné à mesurer la température de l'au moins une cellule secondaire (110) qui est soumise à une pression entre les éléments de pression (103),
l'appareil (1) d'inspection comprenant une unité de correction de courant configurée pour corriger le courant mesuré par l'unité de mesure de courant sur la base d'une courbe d'étalonnage de courant afin de prendre en compte une valeur de température de l'au moins une cellule secondaire (110) mesurée par le capteur de température (109).

2. Appareil d'inspection (1) selon la revendication 1, comprenant en outre un élément de guidage (104) configuré pour guider chaque élément de pression (103) pour qu'il se déplace le long de l'axe principal (X) librement dans la première direction et dans la seconde direction de manière à ajuster l'espace (120) séparant deux éléments de pression adjacents (103).

3. Appareil d'inspection (1) selon l'une quelconque des revendications 1 ou 2, dans lequel le capteur de température (109) comprend l'un des éléments suivants : un thermocouple, un détecteur de température à résistance, une thermistance, un capteur de température à circuit intégré.

4. Appareil d'inspection (1) selon l'une quelconque des revendications 1 à 3, dans lequel le capteur de température (109) a une résolution comprise entre 0,05°C et 0,5°C.

5. Appareil d'inspection (1) selon l'une quelconque des revendications 1 à 4, dans lequel le capteur de température (109) a une plage de température de fonctionnement comprise entre 5°C et 120°C.

6. Appareil d'inspection (1) selon l'une quelconque des revendications 1 à 5, dans lequel la source d'énergie est apte à appliquer une tension pour atteindre une valeur de tension par rapport à l'au moins une cellule secondaire mise sous pression par l'élément de pression.

7. Appareil d'inspection (1) selon l'une quelconque des revendications 1 à 6, comprenant en outre un module d'électrode connecté à chacune des bornes d'électrode de l'au moins une cellule secondaire (110) pour ainsi appliquer ou recevoir du courant.

8. Appareil d'inspection (1) selon l'une quelconque des revendications 1 à 7, comprenant en outre un contrôleur qui est connecté à l'unité d'entraînement de pression, au module d'électrode et à l'unité de correction de courant, respectivement, pour commander l'opération de mise sous pression et de relâchement de l'unité d'entraînement de pression, et pour déterminer s'il y a ou non un défaut dans l'au moins une cellule secondaire (110) en comparant la valeur de courant corrigée donnée par l'unité de correction de courant et une valeur de courant de référence.

9. Appareil d'inspection selon l'une quelconque des revendications 1 à 8, comprenant un cadre destiné à être installé sur un support, l'élément de support (101) étant installé de manière à être perpendiculaire au cadre,
le cadre comprenant un châssis (112) reposant sur le support et une paire de cadres de support (111) prévus de part et d'autre du châssis (112) pour se faire face l'un l'autre,
et dans lequel :
l'unité de mesure de pression comprend un capteur de pression (106) interposé entre un élément fixe fixé pour faire face à l'élément de support (101) et le cadre de support prévu sur un côté du châssis (112),
le capteur de pression (106) étant configuré pour mesurer une pression lorsque les éléments de pression (103) mettent sous pression l'au moins une cellule secondaire (110) lorsque l' unité d'entraînement (105) est dans son premier état de fonctionnement.

10. Appareil d'inspection (1) selon l'une quelconque des revendications 1 à 9, dans lequel l'unité de mesure de pression comprend un capteur de pression compris entre deux éléments de pression adjacents (103) parmi les éléments de pression.

11. Appareil d'inspection (1) selon l'une quelconque des revendications 1 à 10, dans lequel l'espace (120) est destiné à recevoir une seule cellule secondaire (110).

12. Appareil d'inspection (1) selon l'une quelconque des revendications 1 à 11, dans lequel l'élément mobile (102) est mobile en translation selon la première direction et la deuxième direction, entre une première position correspondant au premier état et une deuxième position correspondant au deuxième état.

13. Procédé d'inspection pour inspecter au moins une cellule secondaire, le procédé d'inspection comprenant les étapes suivantes :
- fournir un appareil d'inspection (1) selon l'une quelconque des revendications 1 à 12 ;
- fournir l'au moins une cellule secondaire (110) à inspecter ;
- introduire l'au moins une cellule secondaire (110) dans l'appareil d'inspection (1) de sorte que l'au moins une cellule secondaire (110) soit introduite entre deux éléments de pression adjacents (103) ;
- appliquer une pression sur et libérer l'au moins une cellule secondaire (110) entre les éléments de pression (103) des deux côtés en déplaçant l'élément mobile (102) par rapport à l'élément de support (101) le long d'un axe principal (X) dans une première direction et une seconde direction opposées l'une à l'autre le long de l'axe principal (X) ;
- mesurer la pression appliquée sur l'au moins une cellule secondaire (110) en utilisant l'unité de mesure de pression afin de déterminer si la pression appliquée est dans une plage de pression prédéfinie ;
- appliquer une tension sur l'au moins une cellule secondaire (110) et mesurer un courant correspondant à travers l'au moins une cellule secondaire (110) ;
- mesurer la température de l'au moins une cellule secondaire (110) avec un capteur de température (109) compris dans chaque élément de pression (103) qui est en contact avec l'au moins une cellule secondaire (110) qui est mise sous pression par les éléments de pression (103) ;
- corriger une valeur du courant mesuré sur la base d'une courbe d'étalonnage de courant en tenant compte de la valeur de température mesurée de l'au moins une cellule secondaire (110) par le capteur de température (109) ;
- comparer la valeur de courant corrigée à une valeur de courant de référence ;
- trier l'au moins une cellule secondaire (110) comme étant fonctionnelle ou défectueuse sur la base de la comparaison entre la valeur de courant corrigée et la valeur de courant de référence de telle sorte que :
si la valeur de courant corrigée dépasse la valeur de courant de référence, l'au moins une cellule secondaire (110) est considérée comme défectueuse,
si la valeur de courant corrigée est inférieure à la valeur de courant de référence, l'au moins une cellule secondaire (110) est considérée comme fonctionnelle.

14. Procédé d'inspection selon la revendication 13, dans lequel l'étape consistant à fournir l'au moins une cellule secondaire comprend les sous-étapes suivantes :
- assembler une première électrode (201) et une seconde électrode (202) et un séparateur (203) interposé entre la première électrode (201) et la seconde électrode (202) afin de créer un bobinot ou un empilement ;
- placer le bobinot ou l'empilement dans un boîtier ou un sachet ;
- remplir le boîtier ou le sachet d'un électrolyte ;
- fermer hermétiquement le boîtier ou le sachet afin d'obtenir l'au moins une cellule secondaire (110) ;
- charger l'au moins une cellule secondaire (110) à un état de charge prédéterminé afin de former une interphase d'électrolyte solide sur la surface de la première électrode (201) avant de placer l'au moins une cellule secondaire (110) dans l'appareil d'inspection.

## Patentansprüche

1. Prüfvorrichtung (1) zum Prüfen von mindestens einer Sekundärzelle (110), die Prüfvorrichtung umfassend:
- ein festes Trägerelement (101);
- ein bewegbares Element (102), das installiert ist, um dem Trägerelement (101) gegenüberzuliegen, und relativ zu dem Trägerelement (101) entlang einer Hauptachse (X) in einer ersten Richtung zu dem Trägerelement (101) und einer zu der ersten Richtung entgegengesetzten zweiten Richtung bewegbar ist, wobei jede Richtung entlang der Hauptachse (X) verläuft;
- Druckelemente (103), die zwischen dem Trägerelement (101) und dem bewegbaren Element (102) installiert sind, wobei die Druckelemente (103) entlang der Hauptachse (X) frei bewegbar sind, wobei zwei angrenzende Druckelemente (103) einen Raum (120) definieren, der zum Aufnehmen einer Sekundärzelle (110) bestimmt ist;
- eine Antriebseinheit (105), die konfiguriert ist, um in einem ersten Zustand, in dem die Antriebseinheit (105) die mindestens eine Sekundärzelle (110) zusammendrückt, die sich zwischen den Druckelementen (103) auf beiden Seiten befindet, und in einem zweiten Zustand zu arbeiten, in dem die Antriebseinheit (105) die mindestens eine Sekundärzelle (110) freigibt;
- eine Druckmesseinheit, die konfiguriert ist, um den durch die Antriebseinheit (105) angelegten Druck zu messen;
- eine Stromsteuereinheit, umfassend eine Energiequelle, die konfiguriert ist, um eine Spannung an die mindestens eine Sekundärzelle (110) anzulegen, sowie eine Strommesseinheit zum Messen eines entsprechenden Stroms durch die mindestens eine Sekundärzelle (110)
- jedes Druckelement (103), das mit der mindestens einen Sekundärzelle (110) in Kontakt steht, umfasst einen Temperatursensor (109), wobei der Temperatursensor (109) dafür bestimmt ist, die Temperatur der mindestens einen Sekundärzelle (110) zu messen, die zwischen den Druckelementen (103) einem Druck ausgesetzt ist,
die Prüfvorrichtung (1) umfassend eine Stromkorrektureinheit, die konfiguriert ist, um den durch die Strommesseinheit gemessenen Strom auf Basis einer Stromkalibrierungskurve zu korrigieren, um einen durch den Temperatursensor (109) gemessenen Temperaturwert der mindestens einen Sekundärzelle (110) zu berücksichtigen.

2. Prüfvorrichtung (1) nach Anspruch 1, ferner umfassend ein Führungselement (104), das konfiguriert ist, um jedes Druckelement (103) zu führen, damit es sich entlang der Hauptachse (X) frei in der ersten Richtung und in der zweiten Richtung bewegen kann, um den Spalt (120) anzupassen, der zwei angrenzende Druckelemente (103) trennt.

3. Prüfvorrichtung (1) nach einem der Ansprüche 1 oder 2, wobei der Temperatursensor (109) eines der folgenden Elemente umfasst: ein Thermoelement, einen Widerstandstemperaturdetektor, einen Thermistor, einen Temperatursensor mit integriertem Schaltkreis.

4. Prüfvorrichtung (1) nach einem der Ansprüche 1 bis 3, wobei der Temperatursensor (109) eine Auflösung zwischen 0,05 °C und 0,5 °C aufweist.

5. Prüfvorrichtung (1) nach einem der Ansprüche 1 bis 4, wobei der Temperatursensor (109) einen Betriebstemperaturbereich zwischen 5 °C und 120 °C aufweist.

6. Prüfvorrichtung (1) nach einem der Ansprüche 1 bis 5, wobei die Energiequelle dafür geeignet ist, eine Spannung anzulegen, um einen Spannungswert relativ zu der mindestens einen durch das Druckelement unter Druck gesetzten Sekundärzelle zu erreichen.

7. Prüfvorrichtung (1) nach einem der Ansprüche 1 bis 6, ferner umfassend ein Elektrodenmodul, das mit jedem der Elektrodenanschlüsse der mindestens einen Sekundärzelle (110) verbunden ist, um dadurch Strom anzulegen oder aufzunehmen.

8. Prüfvorrichtung (1) nach einem der Ansprüche 1 bis 7, ferner umfassend eine Steuerung, die mit der Druckantriebseinheit, dem Elektrodenmodul beziehungsweise der Stromkorrektureinheit verbunden ist, um den Druckbeaufschlagungs- und Entlastungsvorgang der Druckantriebseinheit zu steuern und um bei Vergleichen des durch die Stromkorrektureinheit gegebenen korrigierten Stromwerts mit einem Referenzstromwert zu bestimmen, ob in der mindestens einen Sekundärzelle (110) ein Defekt vorliegt oder nicht.

9. Prüfvorrichtung nach einem der Ansprüche 1 bis 8, umfassend einen Rahmen, der dafür bestimmt ist, auf einem Träger installiert zu werden, wobei das Trägerelement (101) installiert ist, so dass es senkrecht zu dem Rahmen ist,
der Rahmen umfassend ein auf dem Träger ruhendes Gestell (112) und ein Paar Trägerrahmen (111), die auf beiden Seiten des Gestells (112) einander zugewandt vorgesehen sind,
und wobei:
die Druckmesseinheit einen Drucksensor (106) umfasst, der zwischen einem dem Trägerelement (101) zugewandten befestigten festen Element und dem auf einer Seite des Gestells (112) vorgesehenen Trägerrahmen eingefügt ist,
wobei der Drucksensor (106) konfiguriert ist, um einen Druck zu messen, wenn die Druckelemente (103) die mindestens eine Sekundärzelle (110) unter Druck setzen, wenn die Antriebseinheit (105) sich in ihrem ersten Betriebszustand befindet.

10. Prüfvorrichtung (1) nach einem der Ansprüche 1 bis 9, wobei die Druckmesseinheit einen Drucksensor umfasst, der zwischen zwei angrenzenden Druckelementen (103) unter den Druckelementen enthalten ist.

11. Prüfvorrichtung (1) nach einem der Ansprüche 1 bis 10, wobei der Raum (120) dafür bestimmt ist, eine einzelne Sekundärzelle (110) aufzunehmen.

12. Prüfvorrichtung (1) nach einem der Ansprüche 1 bis 11, wobei das bewegbare Element (102) in der ersten Richtung und der zweiten Richtung zwischen einer ersten Position, die dem ersten Zustand entspricht, und einer zweiten Position, die dem zweiten Zustand entspricht, translatorisch bewegbar ist.

13. Prüfverfahren zum Prüfen von mindestens einer Sekundärzelle, das Prüfverfahren umfassend die folgenden Schritte:
- Bereitstellen einer Prüfvorrichtung (1) nach einem der Ansprüche 1 bis 12;
- Bereitstellen der mindestens einen zu prüfenden Sekundärzelle (110);
- Einbringen der mindestens einen Sekundärzelle (110) in die Prüfvorrichtung (1), so dass die mindestens eine Sekundärzelle (110) zwischen zwei angrenzenden Druckelementen (103) eingebracht wird;
- Ausüben eines Drucks auf die mindestens eine Sekundärzelle (110) und Freigeben dieser zwischen den Druckelementen (103) auf beiden Seiten bei Bewegen des bewegbaren Elements (102) relativ zu dem Trägerelement (101) entlang einer Hauptachse (X) in einer ersten Richtung und einer zweiten Richtung, die einander entlang der Hauptachse (X) entgegengesetzt sind;
- Messen des auf die mindestens eine Sekundärzelle (110) angelegten Drucks unter Verwendung der Druckmesseinheit, um zu bestimmen, ob der angelegte Druck innerhalb eines vordefinierten Druckbereichs liegt;
- Anlegen einer Spannung an die mindestens eine Sekundärzelle (110) und Messen eines entsprechenden Stroms durch die mindestens eine Sekundärzelle (110);
- Messen der Temperatur der mindestens einen Sekundärzelle (110) mit einem Temperatursensor (109), der in jedem Druckelement (103) enthalten ist, das mit der mindestens einen Sekundärzelle (110) in Kontakt steht, die durch die Druckelemente (103) unter Druck gesetzt wird;
- Korrigieren eines gemessenen Stromwerts auf Basis einer Stromkalibrierungskurve unter Berücksichtigung des durch den Temperatursensor (109) gemessenen Temperaturwerts der mindestens einen Sekundärzelle (110);
- Vergleichen des korrigierten Stromwerts mit einem Referenzstromwert;
- Einsortieren der mindestens einen Sekundärzelle (110) als funktionsfähig oder defekt auf Basis des Vergleichs zwischen dem korrigierten Stromwert und dem Referenzstromwert, so dass:
falls der korrigierte Stromwert den Referenzstromwert überschreitet, die mindestens eine Sekundärzelle (110) als defekt betrachtet wird,
falls der korrigierte Stromwert kleiner als der Referenzstromwert ist, die mindestens eine Sekundärzelle (110) als funktionsfähig betrachtet wird.

14. Prüfverfahren nach Anspruch 13, wobei der Schritt des Bereitstellens der mindestens einen Sekundärzelle die folgenden Teilschritte umfasst:
- Zusammenbauen einer ersten Elektrode (201) und einer zweiten Elektrode (202) und eines zwischen der ersten Elektrode (201) und der zweiten Elektrode (202) eingefügten Separators (203), um eine Spule oder einen Stapel zu erzeugen;
- Platzieren der Spule oder des Stapels in einem Gehäuse oder einem Beutel;
- Füllen des Gehäuses oder des Beutels mit einem Elektrolyten;
- hermetisches Versiegeln des Gehäuses oder des Beutels, um mindestens eine Sekundärzelle (110) zu erhalten;
- Aufladen der mindestens einen Sekundärzelle (110) auf einen vorbestimmten Ladezustand, um eine Festelektrolyt-Grenzfläche auf der Oberfläche der ersten Elektrode (201) zu bilden, bevor die mindestens eine Sekundärzelle (110) in die Prüfvorrichtung eingesetzt wird.

## Claims

1. Inspection apparatus (1) for inspecting at least one secondary cell (110), the inspection apparatus comprising:
- a fixed support element (101);
- a movable element (102) which is installed to face the support element (101) and is movable relative to the support element (101) along a main axis (X) in a first direction toward the support element (101) and a second direction opposite to the first direction, each direction being along the main axis (X);
- pressure elements (103) installed between the support element (101) and the movable element (102), said pressure elements (103) being freely movable along the main axis (X), two adjacent pressure elements (103) defining a space (120) for receiving a secondary cell (110);
- a drive unit (105) configured to operate in a first state in which the drive unit (105) presses the at least one secondary cell (110) located between the pressure elements (103) on both sides, and a second state in which the drive unit (105) releases the at least one secondary cell (110);
- a pressure measurement unit configured to measure the pressure applied by the drive unit (105);
- a current control unit comprising a power source configured to apply a voltage to the at least one secondary cell (110), and a current measurement unit for measuring a corresponding current through the at least one secondary cell (110)
- each pressure element (103) which is in contact with the at least one secondary cell (110) comprises a temperature sensor (109), the temperature sensor (109) being designed to measure the temperature of the at least one secondary cell (110) which is subjected to pressure between the pressure elements (103),
the inspection apparatus (1) comprising a current correction unit configured to correct the current measured by the current measurement unit on the basis of a current calibration curve in order to take into account a temperature value of the at least one secondary cell (110) measured by the temperature sensor (109).

2. Inspection apparatus (1) according to claim 1, further comprising a guide element (104) configured to guide each pressure element (103) to move along the main axis (X) freely in the first direction and in the second direction so as to adjust the space (120) separating two adjacent pressure elements (103).

3. Inspection apparatus (1) according to either of claims 1 or 2, wherein the temperature sensor (109) comprises one of the following elements: a thermocouple, a resistance temperature detector, a thermistor, an integrated circuit temperature sensor.

4. Inspection apparatus (1) according to any of claims 1 to 3, wherein the temperature sensor (109) has a resolution of between 0.05°C and 0.5°C.

5. Inspection apparatus (1) according to any of claims 1 to 4, wherein the temperature sensor (109) has an operating temperature range of between 5°C and 120°C.

6. Inspection apparatus (1) according to any of claims 1 to 5, wherein the power source is able to apply a voltage to achieve a voltage value with respect to the at least one secondary cell pressurized by the pressure element.

7. Inspection apparatus (1) according to any of claims 1 to 6, further comprising an electrode module connected to each of the electrode terminals of the at least one secondary cell (110) to thereby apply or receive current.

8. Inspection apparatus (1) according to any of claims 1 to 7, further comprising a controller which is connected to the pressure drive unit, the electrode module and the current correction unit, respectively, to control the pressurizing and releasing operation of the pressure drive unit, and to determine whether or not there is a fault in the at least one secondary cell (110) by comparing the corrected current value given by the current correction unit and a reference current value.

9. Inspection apparatus according to any of claims 1 to 8, comprising a framework for installation on a support, the support element (101) being installed so as to be perpendicular to the framework,
the framework comprising a frame (112) resting on the support and a pair of support frameworks (111) provided on either side of the frame (112) to face each other,
and wherein:
the pressure measurement unit comprises a pressure sensor (106) interposed between a fixed member fixed to face the support element (101) and the support framework provided on one side of the frame (112),
the pressure sensor (106) being configured to measure a pressure when the pressure elements (103) pressurize the at least one secondary cell (110) when the drive unit (105) is in its first operating state.

10. Inspection apparatus (1) according to any of claims 1 to 9, wherein the pressure measurement unit comprises a pressure sensor between two adjacent pressure elements (103) of the pressure elements.

11. Inspection apparatus (1) according to any of claims 1 to 10, wherein the space (120) is designed to receive a single secondary cell (110).

12. Inspection apparatus (1) according to any of claims 1 to 11, wherein the movable element (102) is translatable in the first direction and the second direction, between a first position corresponding to the first state and a second position corresponding to the second state.

13. Inspection method for inspecting at least one secondary cell, the inspection method comprising the following steps:
- providing an inspection apparatus (1) according to any of claims 1 to 12;
- providing the at least one secondary cell (110) to be inspected;
- introducing the at least one secondary cell (110) into the inspection apparatus (1) so that the at least one secondary cell (110) is introduced between two adjacent pressure elements (103);
- applying pressure to and releasing the at least one secondary cell (110) between the pressure elements (103) on both sides by moving the movable element (102) relative to the support element (101) along a main axis (X) in a first direction and a second direction opposite each other along the main axis (X);
- measuring the pressure applied to the at least one secondary cell (110) using the pressure measurement unit to determine whether the applied pressure is within a predefined pressure range;
- applying a voltage to the at least one secondary cell (110) and measuring a corresponding current through the at least one secondary cell (110);
- measuring the temperature of the at least one secondary cell (110) with a temperature sensor (109) included in each pressure element (103) which is in contact with the at least one secondary cell (110) which is pressurized by the pressure elements (103);
- correcting a measured current value on the basis of a current calibration curve, taking into account the temperature value, measured by the temperature sensor (109), of the at least one secondary cell (110);
- comparing the corrected current value with a reference current value;
- sorting the at least one secondary cell (110) as functional or faulty on the basis of the comparison between the corrected current value and the reference current value so that:
if the corrected current value exceeds the reference current value, the at least one secondary cell (110) is considered faulty,
if the corrected current value is lower than the reference current value, the at least one secondary cell (110) is considered functional.

14. Inspection method according to claim 13, wherein the step of providing the at least one secondary cell comprises the following sub-steps:
- assembling a first electrode (201) and a second electrode (202) and a separator (203) interposed between the first electrode (201) and the second electrode (202) to create a coil or stack;
- placing the coil or stack in a case or bag;
- filling the case or bag with an electrolyte;
- hermetically sealing the case or bag to obtain the at least one secondary cell (110);
- charging the at least one secondary cell (110) to a predetermined state of charge to form a solid electrolyte interphase on the surface of the first electrode (201) before placing the at least one secondary cell (110) in the inspection apparatus.
